# EUROPEAN PATENT APPLICATION

(11) **EP 2 779 256 A2**
(43) Date of publication of application: **17.09.2014**
(21) Application number: 14154805.7
(22) Date of filing: 12.02.2014
(51) Int. Cl.: H01L 33/46

(54) **Semiconductor light emitting element, light emitting device, and method for manufacturing semiconductor light emitting element**

(30) Priority: 14.03.2013 JP 2013052527
(71) Applicant: Kabushiki Kaisha Toshiba, Tokyo (JP)
(72) Inventor: Yamada, Shinji, Tokyo (JP); Katsuno, Hiroshi, Tokyo (JP); Mitsugi, Satoshi, Tokyo (JP); Sugiyama, Naoharu, Tokyo (JP); Nunoue, Shinya, Tokyo (JP)
(74) Representative: Granleese, Rhian Jane

(57) **Abstract**

A semiconductor light emitting element (110, 111, 112, 113, 114, 115, 116, 117) includes a stacked body (SB), a first metal layer (51), and a second metal layer (52). The stacked body (SB) includes a first semiconductor layer (10), a second semiconductor layer (20), and a light emitting layer (30). The second semiconductor layer (20) is separated from the first semiconductor layer (10) in a first direction. The light emitting layer (30) is provided between the first semiconductor layer (10) and the second semiconductor layer (20). The first metal layer (51) is stacked with the stacked body (SB) in the first direction to be electrically connected to one selected from the first semiconductor layer (10) and the second semiconductor layer (20). The first metal layer (51) has a side surface (51s) extending in the first direction. The second metal layer (52) covers at least a portion of the side surface (51s) of the first metal layer (51). A reflectance of the second metal layer (52) is higher than a reflectance of the first metal layer (51).

## Description

### FIELD

Embodiments described herein relate generally to a semiconductor light emitting element, a light emitting device, and a method for manufacturing semiconductor light emitting element.

### BACKGROUND

There are semiconductor light emitting elements such as light emitting diodes, laser diodes, etc. There is a light emitting device that uses such a semiconductor light emitting element. In the semiconductor light emitting element, a support substrate of Si, Cu, or the like is used to support a semiconductor crystal layer. It is desirable to increase the light extraction efficiency of such a semiconductor light emitting element and light emitting device including the support substrate.

### BRIEF DESCRIPTION OF THE DRAWINGS

FIGS. 1A and 1B are schematic views showing a semiconductor light emitting element according to a first embodiment;
FIG. 2 is a schematic cross-sectional view showing a light emitting device according to the first embodiment;
FIGS. 3A to 3D are schematic cross-sectional views showing the method for manufacturing the semiconductor light emitting element according to the first embodiment;
FIGS. 4A to 4D are schematic cross-sectional views showing the method for manufacturing the semiconductor light emitting element according to the first embodiment;
FIGS. 5A to 5D are schematic cross-sectional views showing the method for manufacturing the semiconductor light emitting element according to the first embodiment;
FIGS. 6A to 6D are schematic cross-sectional views showing the method for manufacturing the semiconductor light emitting element according to the first embodiment;
FIGS. 7A and 7B are schematic cross-sectional views showing another method for manufacturing the semiconductor light emitting element according to the first embodiment;
FIG. 8 is a schematic cross-sectional view showing another semiconductor light emitting element according to the first embodiment;
FIGS. 9A to 9D are schematic cross-sectional views showing a method for manufacturing the semiconductor light emitting element according to the first embodiment;
FIGS. 10A to 10C are schematic cross-sectional views showing other semiconductor light emitting elements according to the first embodiment;
FIGS. 11A and 11B are schematic cross-sectional views showing other semiconductor light emitting elements according to the first embodiment;
FIG. 12 is a schematic cross-sectional view showing another semiconductor light emitting element according to the first embodiment;
FIG. 13 is a schematic cross-sectional view showing another light emitting device according to the first embodiment; and
FIG. 14 is a flowchart showing a method for manufacturing a semiconductor light emitting element according to a second embodiment.

### DETAILED DESCRIPTION

According to one embodiment, a semiconductor light emitting element includes a stacked body, a first metal layer, and a second metal layer. The stacked body includes a first semiconductor layer, a second semiconductor layer, and a light emitting layer. The first semiconductor layer is of a first conductivity type. The second semiconductor layer is of a second conductivity type and is separated from the first semiconductor layer in a first direction. The light emitting layer is provided between the first semiconductor layer and the second semiconductor layer. The first metal layer is stacked with the stacked body in the first direction to be electrically connected to one selected from the first semiconductor layer and the second semiconductor layer. The first metal layer has a side surface extending in the first direction. The second metal layer covers at least a portion of the side surface of the first metal layer. A reflectance of the second metal layer is higher than a reflectance of the first metal layer.

According to another embodiment, a light emitting device includes a semiconductor light emitting element, a mounting substrate, and a wavelength conversion layer. The semiconductor light emitting element includes a stacked body, a first metal layer, and a second metal layer. The stacked body includes a first semiconductor layer, a second semiconductor layer, and a light emitting layer. The first semiconductor layer is of a first conductivity type. The second semiconductor layer is of a second conductivity type and is separated from the first semiconductor layer in a first direction. The light emitting layer is provided between the first semiconductor layer and the second semiconductor layer. The first metal layer is stacked with the stacked body in the first direction to be electrically connected to one selected from the first semiconductor layer and the second semiconductor layer. The first metal layer has a side surface extending in the first direction. The second metal layer covers at least a portion of the side surface of the first metal layer. A reflectance of the second metal layer is higher than a reflectance of the first metal layer. The mounting substrate supports the semiconductor light emitting element. The wavelength conversion layer is configured to cover the element, cover at least a portion of the mounting substrate, oppose the side surface of the first metal layer, and cover at least a portion of the second metal layer to convert a wavelength of light emitted from the light emitting layer.

According to another embodiment, a method is disclosed for manufacturing a semiconductor light emitting element. The method can include preparing a workpiece. The workpiece includes a growth substrate and a stacked film. The stacked film is provided on the growth substrate. The stacked film includes a first semiconductor, a second semiconductor film, and a light emitting film. The first semiconductor film is of a first conductivity type. The second semiconductor film is of a second conductivity type and is separated from the first semiconductor film in a stacking direction of the growth substrate and the stacked film. The light emitting film is provided between the first semiconductor film and the second semiconductor film. The method can include forming a plurality of metal layers on the stacked film. Each of the metal layers has a side surface extending in the stacking direction. The method can include forming a metal film on the stacked film and on each of the metal layers to cover at least a portion of the side surface of each of the metal layers. A reflectance of the metal film is higher than a reflectance of each of the metal layers.

Various embodiments will be described hereinafter with reference to the accompanying drawings.

The drawings are schematic or conceptual; and the relationships between the thicknesses and widths of portions, the proportions of sizes between portions, etc., are not necessarily the same as the actual values thereof. Further, the dimensions and/or the proportions may be illustrated differently between the drawings, even for identical portions.

In the drawings and the specification of the application, components similar to those described in regard to a drawing thereinabove are marked with like reference numerals, and a detailed description is omitted as appropriate.

### First embodiment

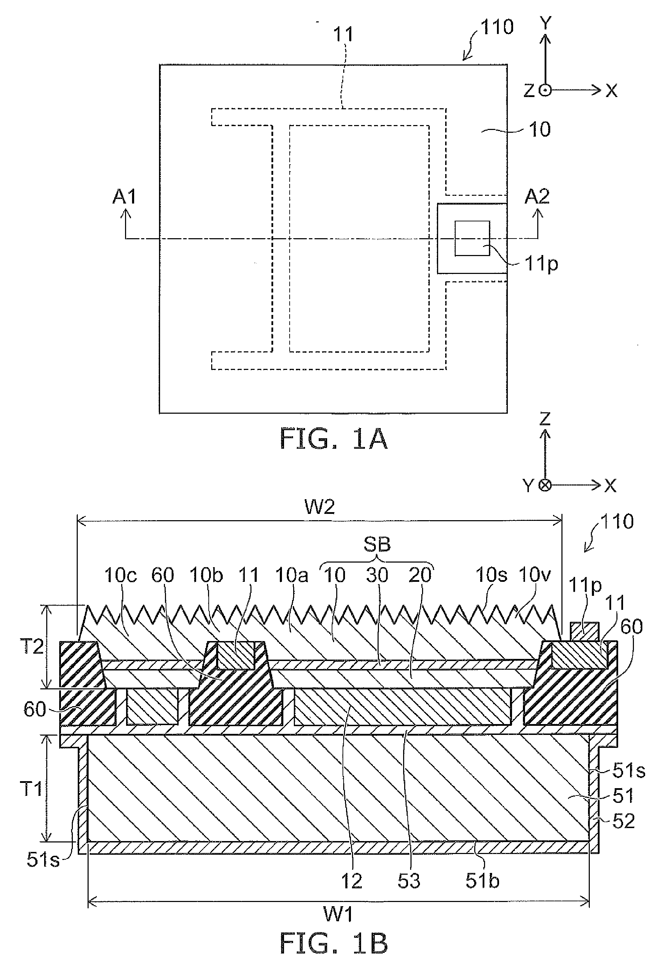

FIGS. 1A and 1B are schematic views showing a semiconductor light emitting element according to a first embodiment.

FIG. 1A is a schematic plan view; and FIG. 1B is a schematic cross-sectional view showing the cross section along line A1-A2 of FIG. 1A.

As shown in FIG. 1A and FIG. 1B, the semiconductor light emitting element 110 according to the embodiment includes a stacked body SB, a first metal layer 51, and a second metal layer 52. In FIG. 1B, the dimensions of the components are illustrated differently from those of FIG. 1A for better viewing of the configurations of the components of the stacked body SB, etc.

The stacked body SB includes a first semiconductor layer 10, a second semiconductor layer 20, and a light emitting layer 30.

The first semiconductor layer 10 includes a nitride semiconductor and has a first conductivity type. For example, the first conductivity type is an n-type; and a second conductivity type is a p-type. The first conductivity type may be the p-type; and the second conductivity type may be the n-type. Hereinbelow, the case is described where the first conductivity type is the n-type and the second conductivity type is the p-type. The first semiconductor layer 10 includes, for example, a GaN layer including an impurity of the n-type. The impurity of the n-type includes, for example, Si.

The second semiconductor layer 20 is separated from the first semiconductor layer 10 in the first direction. In the example, the first direction is taken as a Z-axis direction. The first direction is a direction perpendicular to, for example, the film surface of the first semiconductor layer 10. One direction perpendicular to the Z-axis direction is taken as an X-axis direction. A direction perpendicular to the Z-axis direction and the X-axis direction is taken as a Y-axis direction.

The second semiconductor layer 20 includes a nitride semiconductor and has the second conductivity type. The second semiconductor layer 20 includes, for example, a GaN layer including an impurity of the p-type. The impurity of the p-type includes, for example, Mg. The thickness of the second semiconductor layer 20 is thinner than, for example, the thickness of the first semiconductor layer 10. The thickness of the second semiconductor layer 20 may be equal to or greater than the thickness of the first semiconductor layer 10.

The light emitting layer 30 is provided between the first semiconductor layer 10 and the second semiconductor layer 20. The Z-axis direction (the first direction) corresponds to, for example, the stacking direction of the first semiconductor layer 10, the second semiconductor layer 20, and the light emitting layer 30.

The light emitting layer 30 includes, for example, a nitride semiconductor. The light emitting layer 30 includes, for example, multiple barrier layers and a well layer provided between the multiple barrier layers. The barrier layers and the well layer are stacked along the Z-axis direction. The light emitting layer 30 has, for example, a MQW (Multi-Quantum Well) structure. The light emitting layer 30 may have a SQW (Single-Quantum Well) structure. The barrier layer includes, for example, a GaN layer. The well layer includes, for example, an InGaN layer.

A current is caused to flow in the light emitting layer 30 by applying a voltage between the first semiconductor layer 10 and the second semiconductor layer 20. Thereby, light is emitted from the light emitting layer 30.

The first semiconductor layer 10 has a surface 10s. The surface 10s is opposite to the light emitting layer 30. In the semiconductor light emitting element 110, the surface 10s is used as the light extraction surface. An unevenness 10v is provided in the surface 10s. The surface 10s is surface-roughened. Thereby, total internal reflections at the surface 10s of the light emitted from the light emitting layer 30 can be suppressed; and the light extraction efficiency can be increased.

The first metal layer 51 is stacked with the stacked body SB in the Z-axis direction. The stacked body SB is provided, for example, on the first metal layer 51. In the example, the second semiconductor layer 20 is disposed between the first semiconductor layer 10 and the first metal layer 51. In other words, the second semiconductor layer 20 is provided on the first metal layer 51; the light emitting layer 30 is provided on the second semiconductor layer 20; and the first semiconductor layer 10 is provided on the light emitting layer 30. For example, the first metal layer 51 supports the stacked body SB. The first metal layer 51 is, for example, a metal substrate.

The first metal layer 51 has a side surface 51s extending in the Z-axis direction. The side surface 51s may be substantially parallel to the Z-axis direction and may be tilted with respect to the Z-axis direction. It is sufficient for the side surface 51s to have at least a component extending in the Z-axis direction. In other words, it is sufficient for the side surface 51s not to be a plane orthogonal to the Z-axis direction.

The first metal layer 51 further has a bottom surface 51 b. The bottom surface 51 b is opposite to the stacked body SB. The bottom surface 51 b is, for example, a surface substantially orthogonal to the Z-axis direction.

The first metal layer 51 is electrically conductive. In the example, the first metal layer 51 is electrically connected to the second semiconductor layer 20. The first metal layer 51 may be electrically connected to, for example, the first semiconductor layer 10. The first metal layer 51 is electrically connected to one selected from the first semiconductor layer 10 and the second semiconductor layer 20.

A length T1 of the first metal layer 51 in the Z-axis direction is longer than a length T2 of the stacked body SB in the Z-axis direction. In other words, the thickness of the first metal layer 51 is thicker than the thickness of the stacked body SB. The length T1 of the first metal layer 51 is, for example, not less than 5 times the length T2 of the stacked body SB. The length T1 of the first metal layer 51 is, for example, not more than 100 times the length T2 of the stacked body SB. The length T2 of the stacked body SB is, for example, not less than 1 µm and not more than 10 µm. The length T1 of the first metal layer 51 is, for example, not less than 10 µm and not more than 1000 µm.

A length W1 of the first metal layer 51 in the X-axis direction (the second direction) is longer than a length W2 of the stacked body SB in the X-axis direction. In other words, the width of the first metal layer 51 is wider than the width of the stacked body SB. The difference *W1-W2* between the length W1 of the first metal layer 51 and the length W2 of the stacked body SB is, for example, not less than 10 µm and not more than 100 µm. Thereby, for example, the first metal layer 51 can support the stacked body SB appropriately. The length W1 of the first metal layer 51 may be shorter than the length W2 of the stacked body SB. The length W1 of the first metal layer 51 may be designed appropriately, for example, to be able to support the stacked body SB.

The second metal layer 52 covers at least a portion of the side surface 51 s of the first metal layer 51. In the example, the second metal layer 52 covers the entire side surface 51s of the first metal layer 51. The side surface 51s has, for example, an annular configuration that is continuous around the Z axis. The second metal layer 52 covers the side surface 51 s in, for example, an annular configuration. Similarly, the second metal layer 52 is continuous around the Z axis. In the example, the second metal layer 52 also covers the bottom surface 51 b of the first metal layer 51. So, at least a portion of the first metal layer 51 is provided between the stacked body SB and the second metal layer 52. The thickness of the second metal layer 52 is, for example, thinner than the thickness of the first metal layer 51. The thickness of the second metal layer 52 is, for example, not less than 5 µm and not more than 50 µm. More favorably, the thickness of the second metal layer 52 is, for example, not less than 10 µm and not more than 30 µm.

The reflectance of the second metal layer 52 is, for example, higher than the reflectance of the first metal layer 51. The reflectance is, for example, the reflectance for the light emitted from the light emitting layer 30. The thermal conductivity of the first metal layer 51 is, for example, higher than the thermal conductivity of the second metal layer 52. The coefficient of thermal expansion of the second metal layer 52 is, for example, lower than the coefficient of thermal expansion of the first metal layer 51. For example, the coefficient of linear expansion of the second metal layer 52 is lower than the coefficient of linear expansion of the first metal layer 51. The second metal layer 52 is, for example, electrically conductive. The second metal layer 52 is electrically connected to, for example, the first metal layer 51.

The first metal layer 51 includes, for example, at least one selected from Si, Cu, Ni, and Au. The second metal layer 52 includes, for example, at least one selected from Ni, Ag, and Al. The first metal layer 51 and the second metal layer 52 may have, for example, single-layer structures made of one metal material each or may have multilayered structures made of two or more metal materials each. For example, the second metal layer 52 may have a multilayered structure including a layer including Ag and a layer including Ni. For example, the layer including Ni is disposed between the first metal layer 51 and the layer including Ag. Thereby, for example, the adhesion between the first metal layer 51 and the second metal layer 52 can be improved.

The semiconductor light emitting element 110 further includes, for example, a first electrode 11, a second electrode 12, an intermediate metal layer 53, and an insulating layer 60.

The first semiconductor layer 10 has a first portion 10a overlapping the second semiconductor layer 20 and a second portion 10b not overlapping the second semiconductor layer 20 when projected onto a plane (the X-Y plane) perpendicular to the Z-axis direction. The insulating layer 60 is provided at least between the second portion 10b and the first metal layer 51. The first electrode 11 is provided between the second portion 10b and the insulating layer 60 and is electrically connected to the first semiconductor layer 10. The insulating layer 60 electrically insulates, for example, the first electrode 11 from the second semiconductor layer 20. The insulating layer 60 electrically insulates, for example, the first electrode 11 from the light emitting layer 30. The insulating layer 60 suppresses, for example, shorts that occur between the first semiconductor layer 10 and the second semiconductor layer 20 via the first electrode 11.

In the example, the first electrode 11 has a portion extending in the X-axis direction and a portion extending in the Y-axis direction. In the example, the configuration of the first electrode 11 projected onto the X-Y plane is, for example, a quadrilateral annular configuration. Similarly, the insulating layer 60 has a quadrilateral annular configuration. Therefore, in the semiconductor light emitting element 110, the second semiconductor layer 20 and the light emitting layer 30 are divided by the first electrode 11 and the insulating layer 60. In the semiconductor light emitting element 110, the first semiconductor layer 10 further has a third portion 10c. The third portion 10c overlaps the second semiconductor layer 20 when projected onto the X-Y plane. The first portion 10a is, for example, a portion of the first semiconductor layer 10 inside the first electrode 11 and the insulating layer 60. The third portion 10c is, for example, a portion of the first semiconductor layer 10 outside the first electrode 11 and the insulating layer 60.

The first electrode 11 is, for example, reflective to the light emitted from the light emitting layer 30. The first electrode 11 includes, for example, at least one selected from Ti, Pt, Al, Ag, Ni, Au, and Ta. The first electrode 11 includes, for example, an alloy including at least one selected from Ti, Pt, Al, Ag, Ni, Au, and Ta. It is more desirable for the first electrode 11 to include at least one selected from Al and Ag. Thereby, for example, the first electrode 11 may have a high reflectivity for the light emitted from the light emitting layer 30; and the light extraction efficiency can be increased. The thickness of the first electrode 11 is, for example, not less than 10 nm and not more than 10 µm. Further, considering the necessary film thickness of the reflective film calculated from the plasma frequency and considering the decrease of the operating voltage, it is more desirable for the thickness of the first electrode 11 to be not less than 100 nm and not more than 1 µm.

A first pad unit 11p is provided in the first electrode 11. The first pad unit 11p is used as, for example, an interconnect between the first electrode 11 and external members. The first pad unit 11p includes, for example, at least one metal selected from Ti, Pt, Al, Ag, and Au or an alloy including the at least one metal.

The insulating layer 60 includes, for example, a dielectric film, etc. For example, an oxide film, a nitride film, or the like is used as the dielectric film. For example, a silicon oxide film (e.g., SiO₂) or the like is used as the oxide film.

The second electrode 12 is provided between the second semiconductor layer 20 and the first metal layer 51. The second electrode 12 is electrically connected to the second semiconductor layer 20 and the first metal layer 51. The second electrode 12 is reflective to, for example, the light emitted from the light emitting layer 30. The second electrode 12 includes, for example, Ag. The second electrode 12 includes, for example, one selected from Ag and an Ag alloy. Thereby, for example, a second electrode 12 having high reflectivity is obtained. The thickness of the second electrode 12 is, for example, not less than 10 nm and not more than 10 µm. Considering the necessary film thickness of the reflective film calculated from the plasma frequency and considering the decrease of the operating voltage, it is more desirable for the thickness of the second electrode 12 to be, for example, not less than 100 nm and not more than 1 µm.

The intermediate metal layer 53 is provided between the second electrode 12 and the first metal layer 51. In the example, the intermediate metal layer 53 also extends between the insulating layer 60 and the first metal layer 51. In the example, the intermediate metal layer 53 also extends between the second electrode 12 and the insulating layer 60. The intermediate metal layer 53 includes, for example, at least one selected from Ti, W, Pt, Au, Cu, Ni, Ag, Co, Sn, Pd, and Al. The intermediate metal layer 53 includes, for example, an alloy including at least one selected from Ti, W, Pt, Au, Cu, Ni, Ag, Co, Sn, Pd, and Al. For example, the intermediate metal layer 53 includes a metal having a high reflectance such as Ag, etc. Thereby, for example, reflections of the light are promoted; and the light extraction efficiency can be increased further. The intermediate metal layer 53 functions as, for example, a bonding metal layer that increases the adhesion between the second electrode 12 and the first metal layer 51 and between the insulating layer 60 and the first metal layer 51. The intermediate metal layer 53 also is used as, for example, an electrically conductive layer (a so-called seed layer) when plating the first metal layer 51 and/or the second metal layer 52. The intermediate metal layer 53 may have a single-layer structure made of one metal material or a multilayered structure made of two or more metal materials.

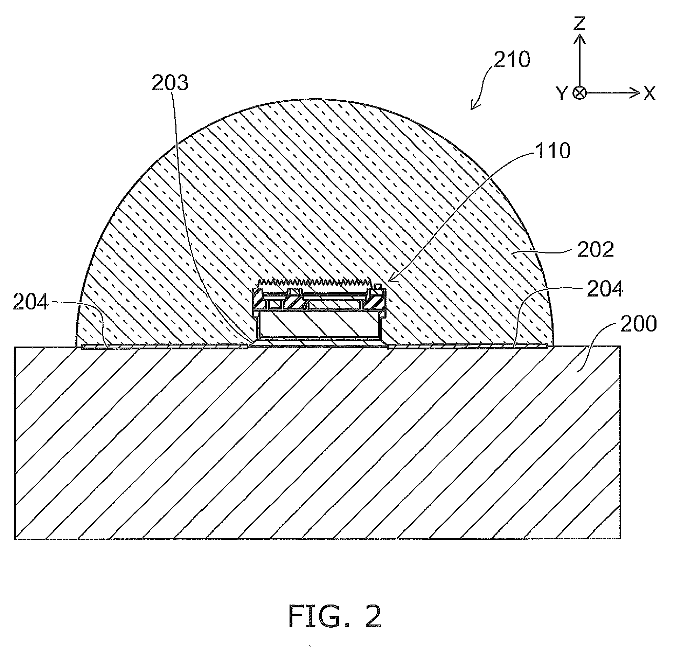

FIG. 2 is a schematic cross-sectional view showing a light emitting device according to the first embodiment.

FIG. 2 is a schematic cross-sectional view showing the light emitting device 210 that uses the semiconductor light emitting element 110 recited above.

As shown in FIG. 2, the light emitting device 210 includes the semiconductor light emitting element 110, a mounting substrate 200, and a wavelength conversion layer 202.

The mounting substrate 200 supports the semiconductor light emitting element 110. The semiconductor light emitting element 110 is provided on the mounting substrate 200. The mounting substrate 200 includes, for example, ceramic, AIN, etc. A bonding layer 203 is provided between the semiconductor light emitting element 110 and the mounting substrate 200. The bonding layer 203 includes, for example, solder, etc.

The mounting substrate 200 includes, for example, an interconnect pattern. For example, the semiconductor light emitting element 110 is electrically connected to the interconnect pattern of the mounting substrate 200 via the bonding layer 203. In particular, the second electrode 12 (the second semiconductor layer 20) of the semiconductor light emitting element 110 is electrically connected to the interconnect pattern of the mounting substrate 200 via the first metal layer 51, the second metal layer 52, the intermediate metal layer 53, and the bonding layer 203.

The wavelength conversion layer 202 covers the semiconductor light emitting element 110 and covers at least a portion of the mounting substrate 200. The wavelength conversion layer 202 opposes the side surface 51 s of the first metal layer 51 and covers at least a portion of the second metal layer 52. The wavelength conversion layer 202 covers, for example, a portion of the second metal layer 52 covering the side surface 51s.

The wavelength conversion layer 202 converts the wavelength of the light emitted from the light emitting layer 30. For example, the wavelength conversion layer 202 absorbs at least a portion of a first light emitted from the light emitting layer 30 and emits a second light having a peak wavelength different from the peak wavelength of the first light. In other words, the wavelength conversion layer 202 converts the peak wavelength of the light emitted from the light emitting layer 30. For example, the wavelength conversion layer 202 may emit light having multiple peak wavelengths different from the peak wavelength of the first light. The wavelength conversion layer 202 includes, for example, a fluorescer layer. The wavelength conversion layer 202 may include, for example, a stacked body of multiple fluorescer layers that emit light having different peak wavelengths. The wavelength conversion layer 202 includes, for example, a ceramic containing a fluorescer, a transparent resin containing a fluorescer, etc.

The light emitted by the light emitting layer 30 is, for example, red light, yellow light, green light, blue light, violet light, or ultraviolet light; and the light emitted from the wavelength conversion layer 202 is, for example, red light, yellow light, green light, blue light, violet light, or ultraviolet light. Synthesized light of the emitted light and the light emitted from the wavelength conversion layer 202 is, for example, substantially white light. The synthesized light may be, for example, red light, yellow light, green light, blue light, violet light, or ultraviolet light. The peak wavelength of the synthesized light may be, for example, any wavelength from the infrared region to the ultraviolet region.

At least a portion of the wavelength conversion layer 202 contacts, for example, the first semiconductor layer 10. The wavelength conversion layer 202 contacts, for example, the surface 10s of the first semiconductor layer 10. Thereby, for example, the light extraction efficiency can be increased. For example, the wavelength conversion layer 202 may not contact the surface 10s.

A reflective layer 204 is provided between the mounting substrate 200 and the wavelength conversion layer 202. The reflectance of the reflective layer 204 is higher than, for example, the reflectance of the mounting substrate 200. The reflective layer 204 includes, for example, a metal material having a high reflectance such as Ag, Al, etc. The reflective layer 204 may be, for example, a white resin, etc. In the case where the white resin or the like is used as the reflective layer 204, for example, the white resin may cover at least a portion of the side surface portion of the second metal layer 52. The side surface portion of the second metal layer 52 is a portion of the second metal layer 52 covering the side surface 51s of the first metal layer 51.

Currently, semiconductor light emitting elements such as LEDs (Light Emitting Diodes) are starting to be used in various applications such as general illumination, backlights for displays, etc. It is considered that it will be necessary to continue increasing the output and reducing the price of LED chips. Improvements to increase the output include increasing the light extraction efficiency and increasing the internal quantum efficiency of the LED semiconductor crystal (the stacked body SB).

There is an LED chip structure called a thin film structure. For the thin film structure, the growth substrate of the LED semiconductor crystal is removed; and the LED semiconductor crystal is supported by a support substrate of Si, Cu, or the like. The inventors of the application discovered that it is important to reduce the absorption of the emitted light at the LED support substrate side surface to further increase the light extraction efficiency of the thin film structure. This is a new challenge discovered by investigations of the inventors of the application.

The absorption of the emitted light at the support substrate side surface is pronounced, for example, for a white LED, etc. According to investigations of the inventors of the application, the light extracted from the LED chip diffuses through the resin that contains the fluorescer and seals the LED chip. Then, the diffused light is absorbed by the support substrate side surface of the LED chip. The inventors of the application discovered the loss of the light output due to this absorption.

Conversely, in the semiconductor light emitting element 110 according to the embodiment and the light emitting device 210 using the semiconductor light emitting element 110, the side surface 51s of the first metal layer 51 is covered with the second metal layer 52 having a high reflectance. Thereby, in the semiconductor light emitting element 110 and the light emitting device 210, the reflected light that is reflected at the wavelength conversion layer 202 can be reflected at the second metal layer 52. In other words, the absorption of the light at the first metal layer 51 can be suppressed. Accordingly, in the semiconductor light emitting element 110 and the light emitting device 210, the light extraction efficiency can be increased further. Although good heat dissipation and a high reflectance can be obtained by the first metal layer 51 including, for example, a metal material such as Ag, etc., the cost may be undesirably higher.

In the light emitting device 210, the reflective layer 204 is provided between the mounting substrate 200 and the wavelength conversion layer 202. Thereby, for example, the absorption of the light at the mounting substrate 200 can be suppressed; and the light extraction efficiency of the light emitting device 210 can be increased further.

To reduce the price further, it may be considered to downsize the LED chip. To obtain a high output by downsizing the LED chip, it is necessary to cause a relatively large current to flow in the LED chip. If heat dissipation measures of the LED chip are insufficient in such a case, the luminous efficiency may undesirably decrease due to heat generation.

Conversely, in the semiconductor light emitting element 110 and the light emitting device 210 according to the embodiment, the first metal layer 51 includes a material having a high thermal conductivity such as Cu, etc. Thereby, for example, good heat dissipation can be obtained. For example, the semiconductor light emitting element 110 can be downsized. For example, the price of the semiconductor light emitting element 110 can be reduced.

In the semiconductor light emitting element 110, the side surface 51s of the first metal layer 51 is covered with the second metal layer 52. For example, the first metal layer 51 includes a material having a high thermal conductivity such as Cu, etc.; and the second metal layer 52 includes a metal material having a reflectance that is higher than that of the first metal layer 51 and a coefficient of thermal expansion that is lower than that of the first metal layer 51. For example, the second metal layer 52 may have a configuration in which metal materials are stacked by firstly forming Ni which has a coefficient of thermal expansion that is lower than that of Cu, and then forming Ag which has a high reflectance. Thereby, in the semiconductor light emitting element 110, the deformation of the first metal layer 51 due to the heat can be suppressed by the second metal layer 52 while maintaining the heat dissipation properties. For example, peeling of the semiconductor light emitting element 110 from the bonding layer 203, etc., can be suppressed. For example, the durability of the semiconductor light emitting element 110 and the light emitting device 210 can be increased.

An example of a method for manufacturing the semiconductor light emitting element 110 according to the embodiment will now be described.

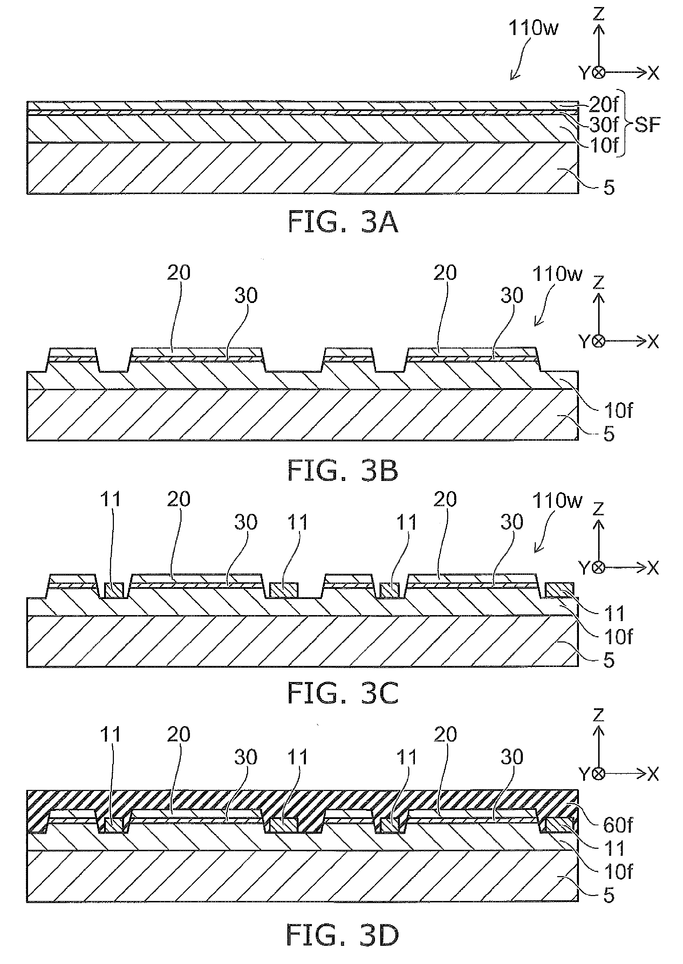

FIGS. 3A to 3D, FIGS. 4A to 4D, FIGS. 5A to 5D, and FIGS. 6A to 6D are schematic cross-sectional views showing the method for manufacturing the semiconductor light emitting element according to the first embodiment.

In the manufacture of the semiconductor light emitting element 110 as shown in FIG. 3A, first, a workpiece 110w is prepared. The workpiece 110w includes a growth substrate 5 and a stacked film SF. The stacked film SF is stacked with the growth substrate 5 in the Z-axis direction. The stacked film SF is provided on the growth substrate 5. The stacked film SF includes a first semiconductor film 10f of the first conductivity type that is used to form the first semiconductor layer 10, a second semiconductor film 20f of the second conductivity type that is used to form the second semiconductor layer 20, and a light emitting film 30f that is used to form the light emitting layer 30.

In the workpiece 110w, the second semiconductor film 20f is separated from the first semiconductor film 10f in the stacking direction (the Z-axis direction) of the growth substrate 5 and the stacked film SF. The light emitting film 30f is provided between the first semiconductor film 10f and the second semiconductor film 20f. In the example, the first semiconductor film 10f is provided on the growth substrate 5; the light emitting film 30f is provided on the first semiconductor film 10f; and the second semiconductor film 20f is provided on the light emitting film 30f. The growth substrate 5 includes, for example, silicon. The growth substrate 5 is, for example, a silicon substrate. The growth substrate 5 may be, for example, a sapphire substrate, etc.

The preparation of the workpiece 110w includes forming the workpiece 110w by, for example, forming the first semiconductor film 10f on the growth substrate 5, forming the light emitting film 30f on the first semiconductor film 10f, and forming the second semiconductor film 20f on the light emitting film 30f.

As shown in FIG. 3B, a portion of the second semiconductor film 20f and a portion of the light emitting film 30f are removed by, for example, photolithography and etching. Thereby, a portion of the first semiconductor film 10f is exposed. Also, the multiple second semiconductor layers 20 are formed from the second semiconductor film 20f; and the multiple light emitting layers 30 are formed from the light emitting film 30f.

As shown in FIG. 3C, the first electrode 11 is formed on the exposed portion of the first semiconductor film 10f by, for example, photolithography, etching, and vapor deposition, sputtering, etc.

As shown in FIG. 3D, an insulating film 60f that is used to form the insulating layer 60 is formed on the workpiece 110w by, for example, film formation.

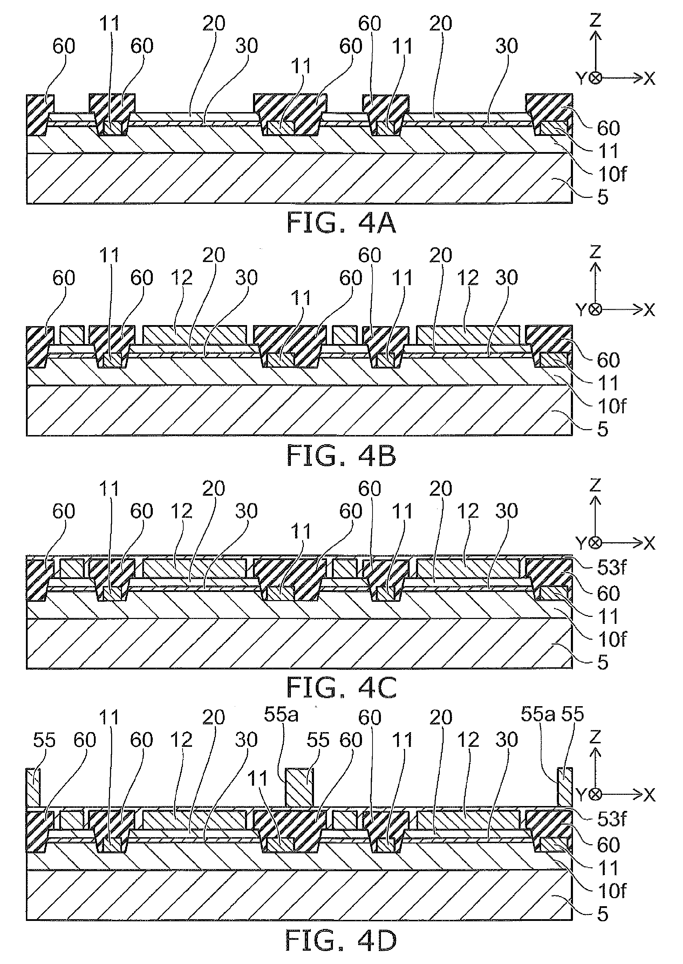

As shown in FIG. 4A, a portion of the insulating film 60f is removed by, for example, photolithography and etching. Thereby, the insulating layer 60 is formed from the insulating film 60f.

As shown in FIG. 4B, the multiple second electrodes 12 are formed respectively on the multiple second semiconductor layers 20 by, for example, photolithography, etching, and vapor deposition, sputtering, etc.

As shown in FIG. 4C, an intermediate metal film 53f that is used to form the intermediate metal layer 53 is formed on the multiple second electrodes 12 and on the insulating layer 60 by, for example, vapor deposition, sputtering, etc. The intermediate metal film 53f (the intermediate metal layer 53) includes, for example, at least one selected from Ti, W, Pt, Au, Cu, Ni, Ag, Co, Sn, Pd, and Al. The intermediate metal film 53f may include an alloy including at least one selected from Ti, W, Pt, Au, Cu, Ni, Ag, Co, Sn, Pd, and Al. By the intermediate metal film 53f including the materials recited above, for example, good adhesion with the first metal layer 51 can be obtained. For example, the intermediate metal film 53f includes a metal having a high reflectance such as Ag, etc. Thereby, the reflections of the light are promoted; and the light extraction efficiency can be increased further.

As shown in FIG. 4D, a mask layer 55 for forming the first metal layers 51 is formed on the intermediate metal film 53f by, for example, photolithography, etching, and vapor deposition, sputtering, etc. The mask layer 55 has multiple openings 55a. The configurations of the openings 55a of the mask layer 55 projected onto the X-Y plane are, for example, substantially the same as the configurations of the first metal layers 51 projected onto the X-Y plane. The mask layer 55 includes, for example, a photoresist, a silicon oxide film (e.g., SiO₂), etc.

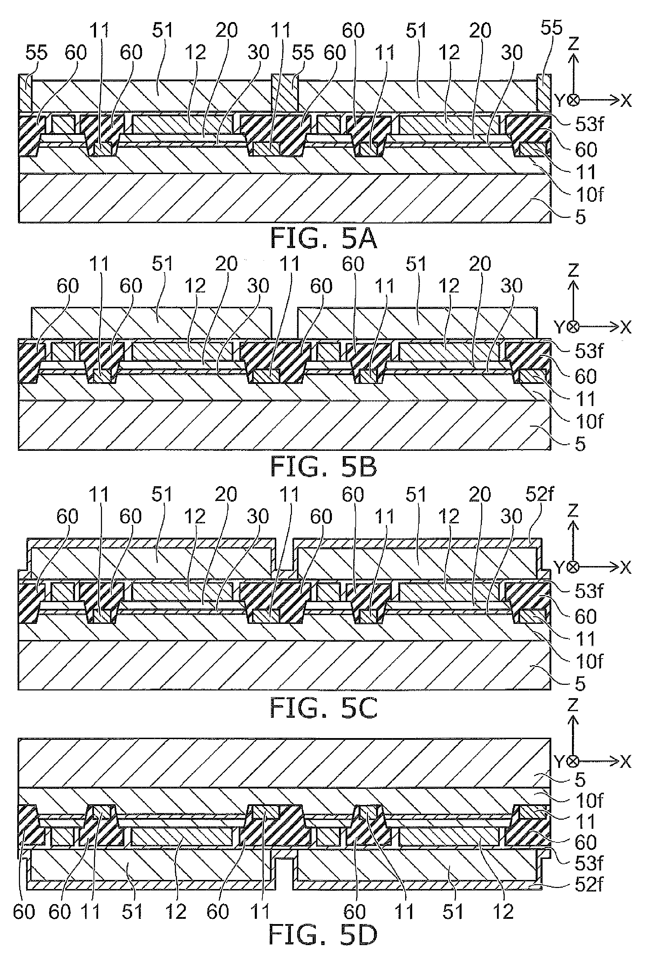

As shown in FIG. 5A, a metal material is deposited on the intermediate metal film 53f exposed from the mask layer 55 by, for example, plating, etc. Thereby, the multiple first metal layers 51 are formed on the intermediate metal film 53f. In other words, the multiple first metal layers 51 are formed respectively on the portions of the stacked film SF overlapping the multiple openings 55a when projected onto the X-Y plane. The first metal layers 51 include, for example, a metal material having a high thermal conductivity such as Cu, etc. Thereby, for example, good heat dissipation can be obtained.

As shown in FIG. 5B, the mask layer 55 is removed by, for example, peeling, etc.

As shown in FIG. 5C, a second metal film 52f that is used to form the second metal layer 52 is formed on a portion of the intermediate metal film 53f and on each of the multiple first metal layers 51 by, for example, plating, vapor deposition, sputtering, etc. In other words, the second metal film 52f is formed on the stacked film SF and on each of the multiple first metal layers 51. The second metal film 52f covers at least a portion of the side surface 51 s of each of the multiple first metal layers 51. The second metal film 52f includes, for example, a metal material having a high reflectance such as Ni, Ag, Al, etc. Thereby, for example, a high light extraction efficiency can be obtained.

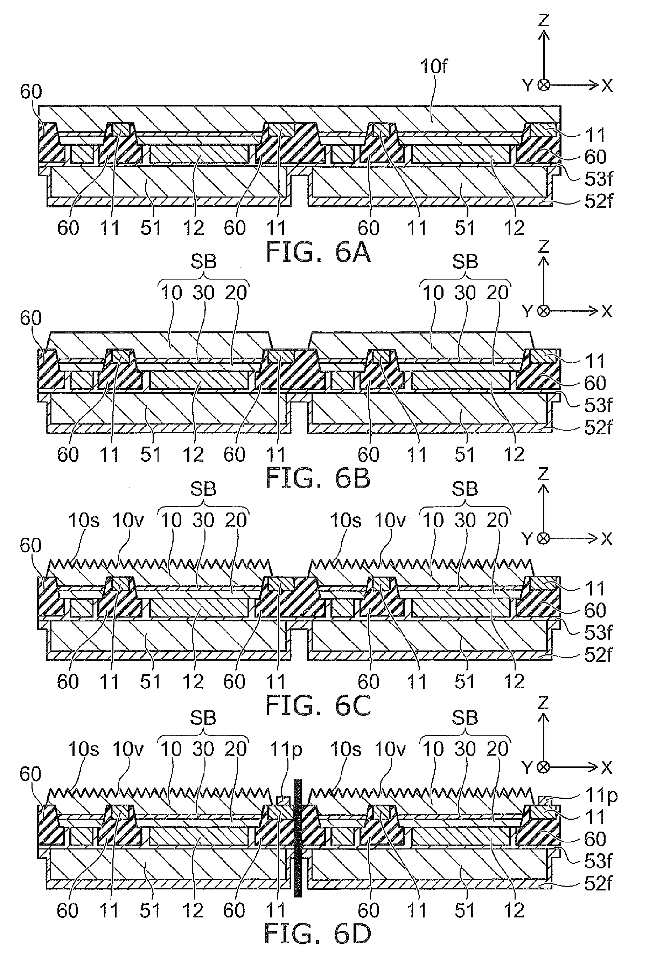

As shown in FIG. 5D and FIG. 6A, the growth substrate 5 is removed. For example, at least one selected from polishing and etching may be used to remove the growth substrate 5. Thereby, the first semiconductor film 10f is exposed.

As shown in FIG. 6B, a portion of the first semiconductor film 10f is removed by, for example, photolithography and etching. Thereby, the first semiconductor layer 10 is formed from the first semiconductor film 10f. Thereby, the stacked body SB is formed. For example, the multiple stacked bodies SB are formed from the first semiconductor film 10f, the second semiconductor film 20f, and the light emitting film 30f. In other words, the multiple stacked bodies SB are formed from the stacked film SF.

As shown in FIG. 6C, a portion of the first semiconductor layer 10 is removed by, for example, etching. Thereby, the unevenness 10v is formed in the surface 10s of the first semiconductor layer 10.

As shown in FIG. 6D, the first pad unit 11p is formed on the first electrode 11 of each of the multiple stacked bodies SB by, for example, photolithography, etching, and film formation. The film formation is performed by, for example, vapor deposition or sputtering.

Subsequently, the semiconductor light emitting element 110 according to the embodiment is completed by singulation into the multiple stacked bodies SB.

For example, in the semiconductor crystal grown on the Si substrate, the dislocation density and/or cracks increase easily due to the lattice mismatch between Si and GaN. In the case where the support substrate of the LED having the thin film structure includes Cu, etc., the internal stress of the Cu is large; and there are cases where the wafer (the growth substrate 5) on which the semiconductor crystal was grown undesirably warps. For example, in the case where a metal layer such as Cu, etc., is formed on the entire surface of the wafer, the internal stress that accumulates in the metal layer becomes large. Therefore, for example, the wafer undesirably warps after the formation of the metal layer. The warp of the wafer causes, for example, lattice defects such as cracks, etc. Therefore, there is a risk that the yield of the semiconductor light emitting element may undesirably decrease.

Conversely, in the method for manufacturing the semiconductor light emitting element according to the embodiment, each of the multiple first metal layers 51 is formed by patterning. Each of the multiple first metal layers 51 is formed in the state of being divided into each element. Thereby, for example, the internal stress that accumulates in the first metal layer 51 can be suppressed even in the case where the first metal layer 51 includes Cu, etc. Thereby, for example, the warp of the growth substrate 5 can be suppressed after the formation of the first metal layer 51. For example, the occurrence of lattice defects in the first semiconductor film 10f, the second semiconductor layer 20, etc., can be suppressed. For example, the decrease of the yield of the semiconductor light emitting element 110 can be suppressed.

In the method for manufacturing the semiconductor light emitting element according to the embodiment, the second metal film 52f is formed on each of the multiple first metal layers 51 after forming the multiple first metal layers 51. The second metal film 52f is continuous with each of the multiple first metal layers 51. Thereby, for example, the unintentional division of the first semiconductor film 10f, etc., in the processes after the formation of the first metal layer 51 can be suppressed. In other words, the second metal film 52f also performs the role of supporting the wafer (the semiconductor crystal layer) to avoid cracks. In the case where the strength provided by only the second metal film 52f is insufficient, a substrate for supporting also may be provided on the second metal film 52f.

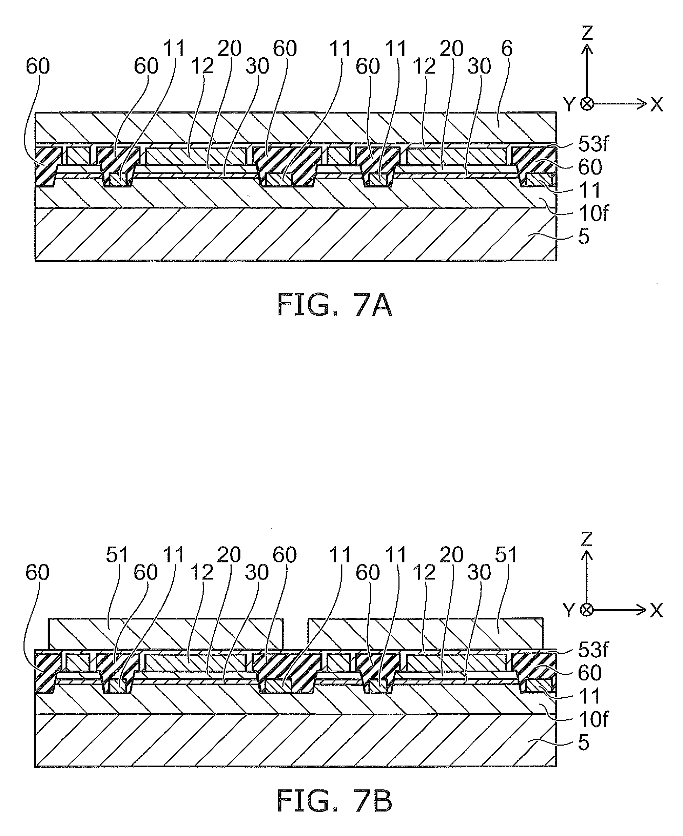

FIGS. 7A and 7B are schematic cross-sectional views showing another method for manufacturing the semiconductor light emitting element according to the first embodiment.

In the example, first, the intermediate metal film 53f is formed by implementing processing that is similar to that of FIGS. 3A to 3D and FIGS. 4A to 4C.

Subsequently, as shown in FIG. 7A, a support substrate 6 is adhered to the intermediate metal film 53f. In other words, the support substrate 6 is adhered to the stacked film SF. The support substrate 6 includes, for example, silicon. The support substrate 6 is, for example, a silicon substrate. For example, AuSn solder, etc., is used to adhere the support substrate 6.

As shown in FIG. 7B, a portion of the support substrate 6 is removed by, for example, photolithography and etching. Thereby, the multiple first metal layers 51 are formed from the support substrate 6. Thereby, for example, the first metal layers 51 that include silicon can be formed.

Thereafter, processing that is similar to that of FIG. 5C, FIG. 5D, and FIG. 6A to FIG. 6D is implemented. Thereby, the semiconductor light emitting element 110 is completed.

Thus, the first metal layers 51 may be formed by adhering the support substrate 6. However, for example, the occurrence of lattice defects can be suppressed by forming the first metal layers 51 by plating, etc., as described above. The manufacturing cost can be lower for the case where the first metal layers 51 are formed by, for example, plating using Cu, etc., than for the case where AuSn solder, etc., is used. Moreover, for example, voids (gaps) occur easily between the intermediate metal film 53f and the support substrate 6 in the method for bonding the support substrate 6. For example, the voids cause the mechanical strength to decrease and undesirably reduce the reliability of the semiconductor light emitting element. Conversely, in the case where the first metal layer 51 is formed by plating, the occurrence of the voids is suppressed; and the reliability can be increased further. Also, the thermal conductivity of the metal material such as Cu, etc., used in the plating is higher than the thermal conductivity of the silicon, etc., used as the support substrate 6. Therefore, the heat dissipation can be higher for the case where the first metal layer 51 is formed by plating than for the case where the first metal layer 51 is formed by adhering the silicon substrate, etc.

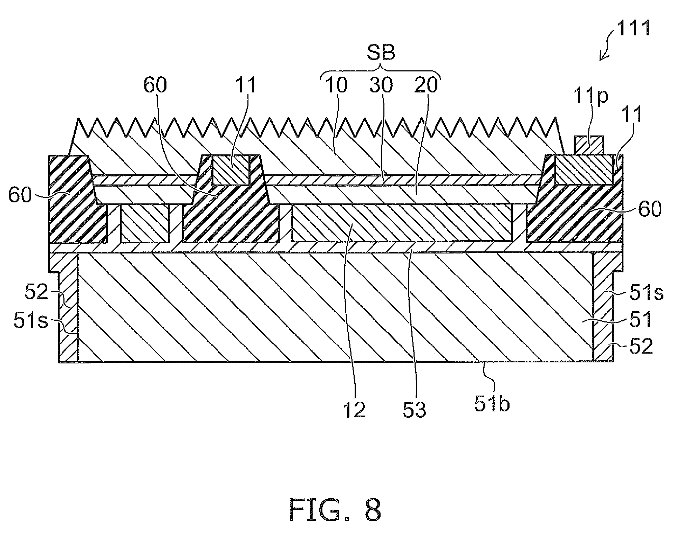

FIG. 8 is a schematic cross-sectional view showing another semiconductor light emitting element according to the first embodiment.

In the semiconductor light emitting element 111 as shown in FIG. 8, the second metal layer 52 covers only the side surface 51s of the first metal layer 51. In other words, in the semiconductor light emitting element 111, the second metal layer 52 does not cover the bottom surface 51 b of the first metal layer 51.

Thus, the second metal layer 52 may cover only the side surface 51s of the first metal layer 51. In the semiconductor light emitting element 111 as well, for example, the absorption of the light at the first metal layer 51 can be suppressed by the light that is reflected at the wavelength conversion layer 202 being reflected at the second metal layer 52. In the semiconductor light emitting element 111 as well, a high light extraction efficiency can be obtained.

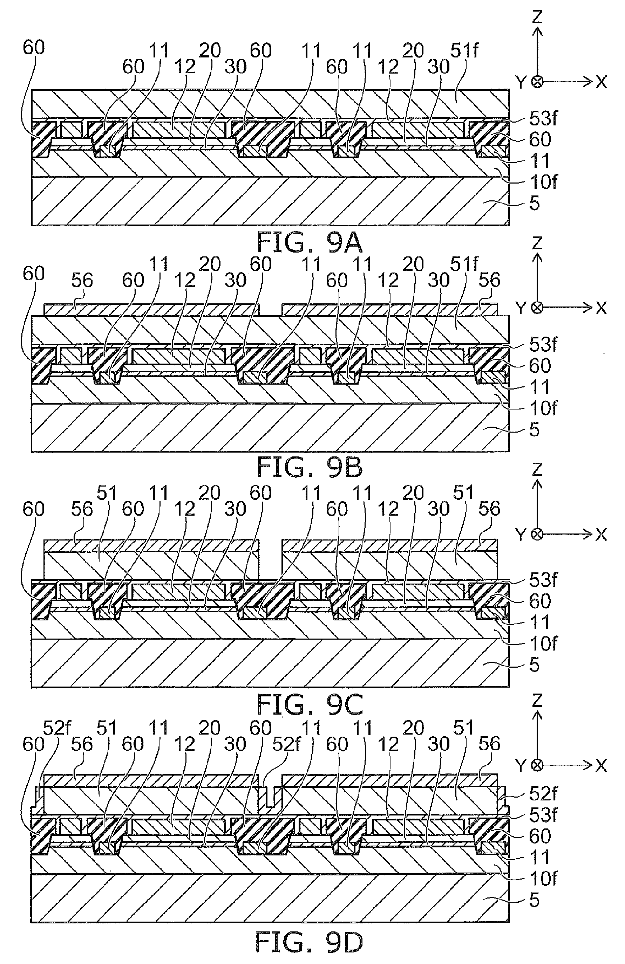

FIGS. 9A to 9D are schematic cross-sectional views showing a method for manufacturing the semiconductor light emitting element according to the first embodiment.

FIGS. 9A to 9D show a portion of the manufacturing processes of the semiconductor light emitting element 111.

In the manufacture of the semiconductor light emitting element 111, first, the intermediate metal film 53f is formed by implementing processing that is similar to that of FIGS. 3A to 3D and FIGS. 4A to 4C.

As shown in FIG. 9A, after forming the intermediate metal film 53f, for example, a first metal film 51f that is used to form the first metal layer 51 is formed on the intermediate metal film 53f by plating, vapor deposition, etc.

As shown in FIG. 9B, a mask layer 56 for forming the first metal layers 51 is formed on the intermediate metal film 53f by photolithography, etching, and vapor deposition, sputtering, etc. The configuration of the mask layer 56 projected onto the X-Y plane is substantially the same as, for example, the configuration of the first metal layers 51 projected onto the X-Y plane. The mask layer 56 includes, for example, a photoresist, a silicon oxide film (e.g., SiO₂), etc.

As shown in FIG. 9C, a portion of the first metal film 51f is removed by, for example, etching. For example, the pattern configuration of the mask layer 56 is transferred onto the first metal film 51f. Thereby, the multiple first metal layers 51 are formed from the first metal film 51f.

As shown in FIG. 9D, for example, the second metal film 52f that is used to form the second metal layer 52 is formed at the portion exposed from the mask layer 56 by plating, vapor deposition, etc., with the mask layer 56 remaining. Subsequently, for example, the mask layer 56 is removed by peeling, etc. Thereby, the second metal layer 52 can be formed to cover only the side surface 51 s of the first metal layer 51.

Thereafter, processing that is similar to that of FIGS. 6A to 6D is implemented. Thereby, the semiconductor light emitting element 111 is completed.

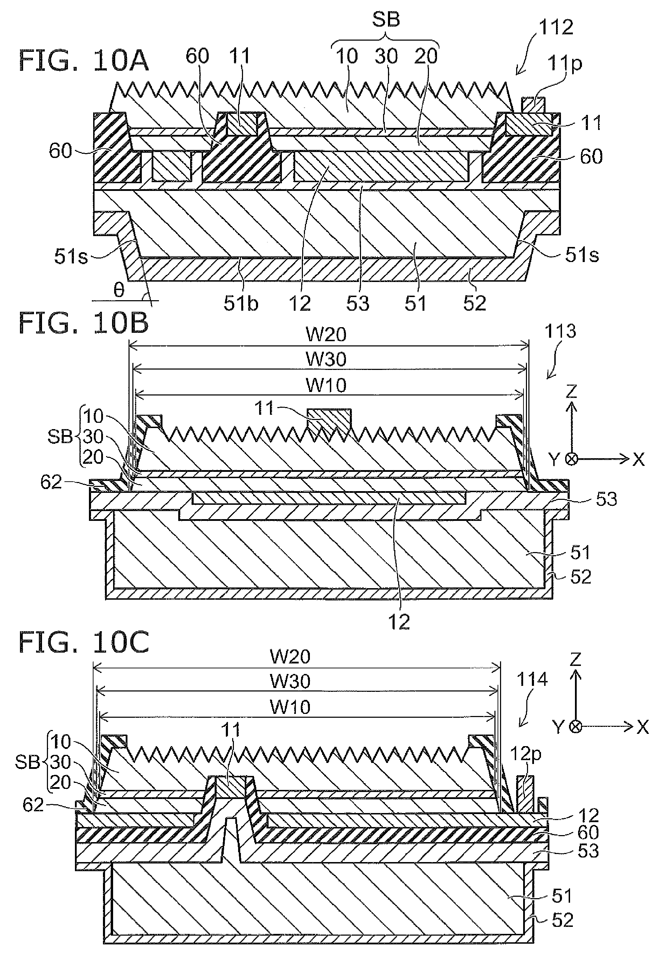

FIGS. 10A to 10C are schematic cross-sectional views showing other semiconductor light emitting elements according to the first embodiment.

In a semiconductor light emitting element 112 as shown in FIG. 10A, the side surface 51s of the first metal layer 51 is tilted with respect to the Z-axis direction. In the semiconductor light emitting element 112, the width of the first metal layer 51 in the X-axis direction decreases in the direction from the stacked body SB toward the first metal layer 51. The side surface 51s is a tapered surface. Thereby, for example, the side surface 51 s can be appropriately covered with the second metal layer 52 when forming the second metal layer 52 by sputtering, vapor deposition, etc. An angle θ between the side surface 51s and the X-Y plane is, for example, not less than 10° and not more than 90°.

In the semiconductor light emitting element 112, a portion of the side surface 51s is not covered with the second metal layer 52. Thus, it is not always necessary for the second metal layer 52 to cover the entire side surface 51 s. It is sufficient for the second metal layer 52 to cover at least a portion of the side surface 51s. The first metal layer 51 may have a tapered configuration in the case where the second metal layer 52 covers the entire side surface 51s as in the semiconductor light emitting element 110. In the semiconductor light emitting element 110, the angle θ between the side surface 51s and the X-Y plane may be set to be not less than 10° and not more than 90°.

In a semiconductor light emitting element 113 as shown in FIG. 10B, the first semiconductor layer 10 is disposed between the first electrode 11 and the light emitting layer 30. In other words, the first electrode 11 is provided on the first semiconductor layer 10. The first electrode 11 is provided on the surface 10s. Thus, the first electrode 11 may be disposed between the first semiconductor layer 10 and the insulating layer 60 or may be disposed on the first semiconductor layer 10. In the semiconductor light emitting element 113, a length W10 of the first semiconductor layer 10 in the X-axis direction is shorter than a length W30 of the light emitting layer 30 in the X-axis direction. The length W30 of the light emitting layer 30 in the X-axis direction is shorter than a length W20 of the second semiconductor layer 20 in the X-axis direction. In other words, in the semiconductor light emitting element 113, the stacked body SB has a tapered configuration. In the example, the length W20 of the second semiconductor layer 20 in the X-axis direction is substantially the same as the length W2 of the stacked body SB in the X-axis direction. Also, in the semiconductor light emitting element 113, a protective film 62 is provided to cover the side surface of the light emitting layer 30. The protective film 62 includes, for example, a silicon oxide film, a silicon nitride film, a silicon oxynitride film, etc. The silicon oxide film includes, for example, SiO₂, etc.

In a semiconductor light emitting element 114 as shown in FIG. 10C, the first metal layer 51 is electrically connected to the first semiconductor layer 10. In the semiconductor light emitting element 114, for example, the first metal layer 51 is electrically connected to the first semiconductor layer 10 via the intermediate metal layer 53 and the first electrode 11. For example, the first electrode 11 contacts the first semiconductor layer 10 and the intermediate metal layer 53. The intermediate metal layer 53 contacts the first electrode 11 and contacts the first metal layer 51. Thereby, the first metal layer 51 is electrically connected to the first semiconductor layer 10.

In the semiconductor light emitting element 114, the insulating layer 60 is provided between the first electrode 11 and the second electrode 12 and between the second electrode 12 and the intermediate metal layer 53. In the semiconductor light emitting element 114, the second electrode 12 is electrically insulated from the first metal layer 51 by the insulating layer 60. In other words, the second semiconductor layer 20 is electrically insulated from the first metal layer 51. A second pad unit 12p is provided on the second electrode 12 in the semiconductor light emitting element 114. The second pad unit 12p is used as, for example, an interconnect between the second electrode 12 and external members.

Thus, the first metal layer 51 may be electrically connected to the first semiconductor layer 10 or may be electrically connected to the second semiconductor layer 20. It is sufficient for the first metal layer 51 to be electrically connected to one selected from the first semiconductor layer 10 and the second semiconductor layer 20. For example, good heat dissipation can be obtained by electrically connecting the first metal layer 51 to one selected from the first semiconductor layer 10 and the second semiconductor layer 20. In the semiconductor light emitting element 114 as well, the length W10 of the first semiconductor layer 10 in the X-axis direction is shorter than the length W30 of the light emitting layer 30 in the X-axis direction. The length W30 of the light emitting layer 30 in the X-axis direction is shorter than the length W20 of the second semiconductor layer 20 in the X-axis direction. In the semiconductor light emitting element 114 as well, the protective film 62 is provided to cover the side surface of the light emitting layer 30.

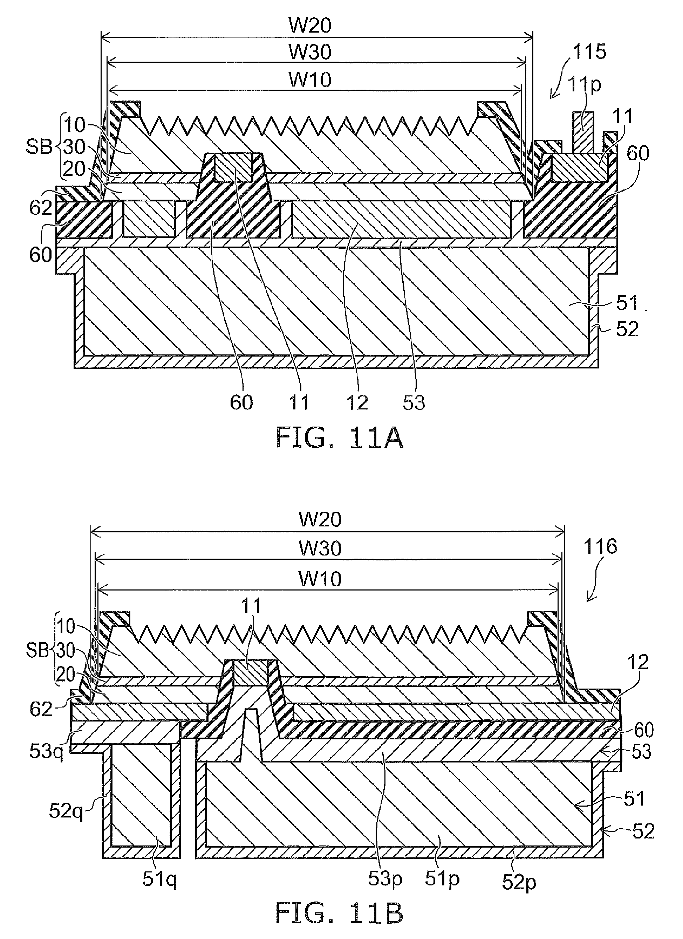

FIGS. 11A and 11B are schematic cross-sectional views showing other semiconductor light emitting elements according to the first embodiment.

In a semiconductor light emitting element 115 as shown in FIG. 11A, the stacked body SB has a tapered configuration in a state in which the first electrode 11 is disposed between the first semiconductor layer 10 and the insulating layer 60, and the first metal layer 51 is electrically connected to the second semiconductor layer 20. In the semiconductor light emitting element 115 as well, the length W10 of the first semiconductor layer 10 in the X-axis direction is shorter than the length W30 of the light emitting layer 30 in the X-axis direction. The length W30 of the light emitting layer 30 in the X-axis direction is shorter than the length W20 of the second semiconductor layer 20 in the X-axis direction.

The semiconductor light emitting element 115 can be formed by, for example, controlling the lengths W10, W20, and W30 in the process of removing the portion of the first semiconductor film 10f shown in FIG. 6B. For example, the formation is possible by controlling the width of the stacked body SB and the tilt angle of the side surface of the stacked body SB in the process of removing the portion of the first semiconductor film 10f. In the semiconductor light emitting element 115 as well, the protective film 62 is provided to cover the side surface of the light emitting layer 30.

In a semiconductor light emitting element 116 as shown in FIG. 11B, the first metal layer 51 includes a first metal portion 51 p and a second metal portion 51 q. In the semiconductor light emitting element 116, the second metal layer 52 includes a third metal portion 52p and a fourth metal portion 52q. Further, in the semiconductor light emitting element 116, the intermediate metal layer 53 includes a fifth metal portion 53p and a sixth metal portion 53q.

The second metal portion 51q is separated (electrically insulated) from the first metal portion 51 p in a direction along the X-Y plane. In the example, the first metal portion 51 p is electrically connected to the first semiconductor layer 10; and the second metal portion 51 q is electrically connected to the second semiconductor layer 20. Conversely, the first metal portion 51 p may be electrically connected to the second semiconductor layer 20; and the second metal portion 51q may be electrically connected to the first semiconductor layer 10. In other words, the first metal portion 51 p is electrically connected to one selected from the first semiconductor layer 10 and the second semiconductor layer 20; and the second metal portion 51 q is electrically connected to the other selected from the first semiconductor layer 10 and the second semiconductor layer 20.

The third metal portion 52p covers at least a portion of the first metal portion 51 p side surface. The fourth metal portion 52q covers at least a portion of the side surface of the second metal portion 51q. The fourth metal portion 52q is separated (electrically insulated) from the first metal portion 51 p and the third metal portion 52p.

The fifth metal portion 53p is provided between the first metal portion 51p and the stacked body SB. The sixth metal portion 53q is provided between the second metal portion 51q and the stacked body SB. The sixth metal portion 53q is separated (electrically insulated) from the first metal portion 51 p, the third metal portion 52p, and the fifth metal portion 53p.

In the semiconductor light emitting element 116, the insulating layer 60 is provided between the second electrode 12 and the fifth metal portion 53p. The fifth metal portion 53p is electrically connected to the first electrode 11 via an opening provided in the insulating layer 60. For example, the fifth metal portion 53p contacts the first electrode 11. Thereby, the first metal portion 51 p is electrically connected to the first semiconductor layer 10 via the first electrode 11 and the fifth metal portion 53p.

The sixth metal portion 53q is provided between the second electrode 12 and the second metal portion 51 q. The sixth metal portion 53q contacts, for example, the second electrode 12. Thereby, the second metal portion 51q is electrically connected to the second semiconductor layer 20 via the second electrode 12 and the sixth metal portion 53q.

Thus, in the semiconductor light emitting element 116, the first metal layer 51, the second metal layer 52, and the intermediate metal layer 53 are subdivided into a portion electrically connected to the first semiconductor layer 10 and a portion electrically connected to the second semiconductor layer 20. Thereby, in the semiconductor light emitting element 116, the conduction to the light emitting layer 30 can be performed via the first metal layer 51, the second metal layer 52, and the intermediate metal layer 53. For example, in the semiconductor light emitting element 116, the conduction can be performed from the surface on the side opposite to the stacked body SB.

In the semiconductor light emitting element 116 as well, the stacked body SB has a tapered configuration. In the semiconductor light emitting element 116 as well, the length W10 of the first semiconductor layer 10 in the X-axis direction is shorter than the length W30 of the light emitting layer 30 in the X-axis direction. The length W30 of the light emitting layer 30 in the X-axis direction is shorter than the length W20 of the second semiconductor layer 20 in the X-axis direction. In the semiconductor light emitting element 116 as well, the protective film 62 is provided to cover the side surface of the light emitting layer 30.

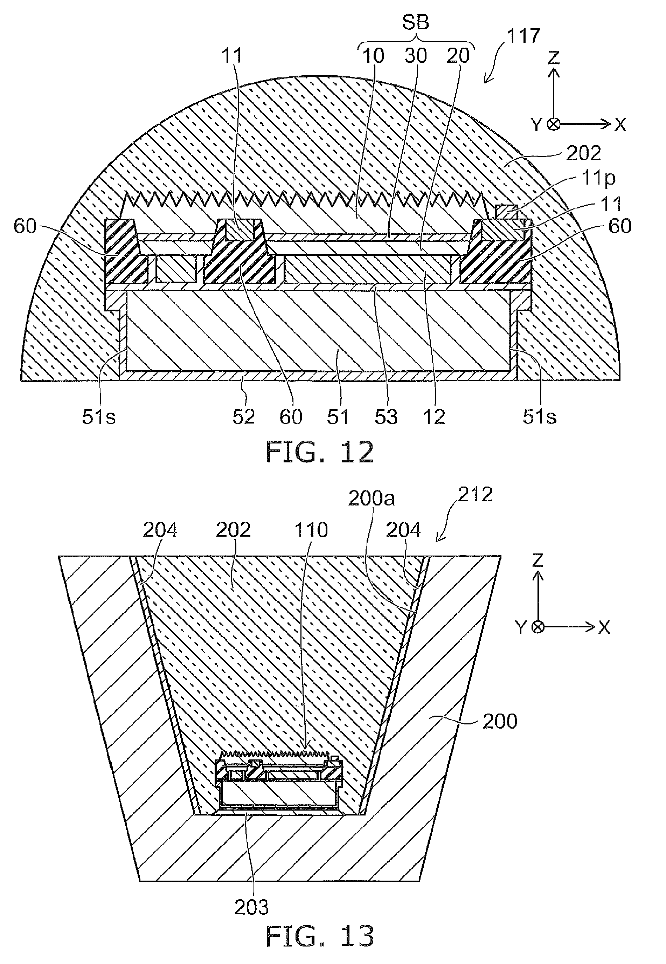

FIG. 12 is a schematic cross-sectional view showing another semiconductor light emitting element according to the first embodiment.

As shown in FIG. 12, the semiconductor light emitting element 117 includes the wavelength conversion layer 202. The wavelength conversion layer 202 covers the stacked body SB, opposes the side surface 51s of the first metal layer 51, and covers at least a portion of the second metal layer 52. The wavelength conversion layer 202 covers, for example, a portion of the second metal layer 52 covering the side surface 51s. Thus, the wavelength conversion layer 202 may be provided in the semiconductor light emitting element.

FIG. 13 is a schematic cross-sectional view showing another light emitting device according to the first embodiment.

In the light emitting device 212 as shown in FIG. 13, the mounting substrate 200 has a recess 200a. The semiconductor light emitting element 110 is provided inside the recess 200a. In the light emitting device 212, the mounting substrate 200 has a cup-like configuration. Thus, the mounting substrate 200 may have a plate configuration or a cup-like configuration.

### Second embodiment

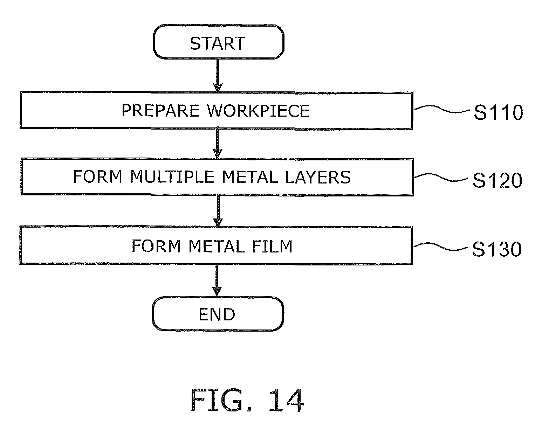

FIG. 14 is a flowchart showing a method for manufacturing a semiconductor light emitting element according to a second embodiment.

As shown in FIG. 14, the method for manufacturing the semiconductor light emitting element according to the embodiment includes step S110 of preparing the workpiece 110w, step S120 of forming the multiple first metal layers 51 (the metal layers), and step S130 of forming the second metal film 52f (the metal film).

In step S110, the workpiece 110w that includes the growth substrate 5 and the stacked film SF is prepared. In step S120, the multiple first metal layers 51 are formed on the stacked film SF. In step S130, the second metal film 52f is formed on the stacked film SF and on each of the multiple first metal layers 51. Thereby, for example, the semiconductor light emitting element 110 that has a high light extraction efficiency is manufactured.

Step S120 includes, for example, a process of forming the mask layer 55 having the multiple openings 55a on the stacked film SF and a process of forming the multiple first metal layers 51 by depositing a metal material on the portions of the stacked film SF respectively overlapping the multiple openings 55a when projected onto the X-Y plane.

Step S120 may include, for example, a process of adhering the support substrate 6 to the stacked film SF and a process of forming the multiple first metal layers 51 from the support substrate 6 by removing a portion of the support substrate 6.

In step S110, the processing described in regard to, for example, FIG. 3A is implemented. In step S120, the processing described in regard to, for example, FIG. 5A or FIG. 7B is implemented. Step S120 also includes, for example, forming the multiple stacked bodies SB from the stacked film SF and forming the multiple first metal layers 51 respectively on the multiple stacked bodies SB. In step S130, the processing described in regard to, for example, FIG. 5C is implemented. Step S130 also includes, for example, forming the second metal film 52f on each of the multiple stacked bodies SB and on each of the multiple first metal layers 51.

According to the embodiments, a semiconductor light emitting element, a light emitting device, and a method for manufacturing the semiconductor light emitting element having a high light extraction efficiency are provided.

In the specification, "nitride semiconductor" includes all compositions of semiconductors of the chemical formula B*ₓ*In*_{y}*Al*_{z}*Ga_{1-*x-y-z*}N (0 ≤ *x* ≤ 1, 0 ≤ *y* ≤ 1, 0 ≤ *z* ≤ 1, and *x+y+z* ≤ 1) for which the composition ratios x, *y,* and z are changed within the ranges respectively. "Nitride semiconductor" further includes Group V elements other than N (nitrogen) in the chemical formula recited above, various elements added to control various properties such as the conductivity type and the like, and various elements included unintentionally.

In the specification of the application, "perpendicular" and "parallel" include not only strictly perpendicular and strictly parallel but also include, for example, the fluctuation due to manufacturing processes, etc.; and it is sufficient to be substantially perpendicular and substantially parallel. In the specification of the application, the state of being "provided on" includes not only the state of being provided in direct contact but also the state of being provided with another component inserted therebetween. The state of being "stacked" includes not only the state of overlapping in contact with each other but also the state of overlapping with another component inserted therebetween. The state of being "opposed" includes not only the state of directly facing each other but also the state of facing each other with another component inserted therebetween. In the specification of the application, being "electrically connected" includes not only the case of being connected in direct contact but also the case of being connected via another electrically conductive member, etc.

Hereinabove, embodiments of the invention are described with reference to specific examples. However, the embodiments of the invention are not limited to these specific examples. For example, one skilled in the art may similarly practice the invention by appropriately selecting specific configurations of components included in the semiconductor light emitting element, the light emitting device, and the method for manufacturing the semiconductor light emitting element such as the first semiconductor layer, the second semiconductor layer, the light emitting layer, the stacked body, the wavelength conversion layer, the first metal layer, the second metal layer, the intermediate metal layer, the first electrode, the second electrode, the insulating layer, the growth substrate, the support substrate, the stacked film, the first semiconductor film, the second semiconductor film, the light emitting film, the workpiece, the metal layer, the metal film, the mask layer, etc., from known art; and such practice is within the scope of the invention to the extent that similar effects are obtained.

Further, any two or more components of the specific examples may be combined within the extent of technical feasibility and are included in the scope of the invention to the extent that the purport of the invention is included.

Moreover, all semiconductor light emitting elements, light emitting devices, and methods for manufacturing the semiconductor light emitting element practicable by an appropriate design modification by one skilled in the art based on the semiconductor light emitting elements, the light emitting devices, and the methods for manufacturing the semiconductor light emitting element described above as embodiments of the invention also are within the scope of the invention to the extent that the spirit of the invention is included.

Various other variations and modifications can be conceived by those skilled in the art within the spirit of the invention, and it is understood that such variations and modifications are also encompassed within the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A semiconductor light emitting element (110, 111, 112, 113, 114, 115, 116, 117), comprising:
a stacked body (SB) including
a first semiconductor layer (10) of a first conductivity type,
a second semiconductor layer (20) of a second conductivity type separated from the first semiconductor layer (10) in a first direction, and
a light emitting layer (30) provided between the first semiconductor layer (10) and the second semiconductor layer (20);
a first metal layer (51) stacked with the stacked body (SB) in the first direction to be electrically connected to one selected from the first semiconductor layer (10) and the second semiconductor layer (20), the first metal layer (51) having a side surface (51s) extending in the first direction; and
a second metal layer (52) covering at least a portion of the side surface (51s) of the first metal layer (51), a reflectance of the second metal layer (52) being higher than a reflectance of the first metal layer (51).

2. The element (110, 111, 112, 113, 114, 115, 116, 117) according to claim 1, wherein a length of the first metal layer (51) in the first direction is longer than a length of the stacked body (SB) in the first direction, and a length of the first metal layer (51) in a second direction perpendicular to the first direction is longer than a length of the stacked body (SB) in the second direction.

3. The element (110, 111, 113, 114, 115, 116, 117) according to any of claims 1 and 2, wherein the second metal layer (52) covers the entire side surface (51 s) of the first metal layer (51).

4. The element (110, 112, 113, 114, 115, 116, 117) according to any of claims 1-3, wherein at least a portion of the first metal layer (51) is provided between the stacked body (SB) and the second metal layer (52).

5. The element (110, 111, 112, 113, 114, 115, 116, 117) according to any of claims 1-4, wherein a thermal conductivity of the first metal layer (51) is higher than a thermal conductivity of the second metal layer (52).

6. The element (110, 111, 112, 113, 114, 115, 116, 117) according to any of claims 1-5, wherein a coefficient of thermal expansion of the second metal layer (52) is lower than a coefficient of thermal expansion of the first metal layer (51).

7. The element (110, 111, 112, 115, 117) according to any of claims 1-6, further comprising an insulating layer (60) and a first electrode (11),
the second semiconductor layer (20) being disposed between the first semiconductor layer (10) and the first metal layer (51),
the first semiconductor layer (10) having a first portion (10a) overlapping the second semiconductor layer (20) and a second portion (10b) not overlapping the second semiconductor layer (20) when projected onto a plane perpendicular to the first direction,
the insulating layer (60) being provided between the second portion (10b) and the first metal layer (51),
the first electrode (11) being provided between the second portion (10b) and the insulating layer (60), the first electrode (11) being electrically connected to the first semiconductor layer (10).

8. The element (113) according to any of claims 1-6, further comprising a first electrode (11) provided on the first semiconductor layer (10), the first electrode (11) being electrically connected to the first semiconductor layer (10),
the second semiconductor layer (20) being disposed between the first semiconductor layer (10) and the first metal layer (51).

9. The element (110, 111, 112, 115, 117) according to claim 7, further comprising a second electrode (12) provided between the second semiconductor layer (20) and the first metal layer (51), the second electrode (20) being electrically connected to the second semiconductor layer (20).

10. The element (110, 111, 112, 115, 117) according to claim 9, further comprising an intermediate metal layer (53) provided between the second electrode (12) and the first metal layer (51).

11. The element (112) according to any of claims 1-10, wherein
the side surface (51s) of the first metal layer (51) is tilted with respect to the first direction, and
the length of the first metal layer (51) in a second direction perpendicular to the first direction is configured to decrease in a direction from the stacked body (SB) toward the first metal layer (51).

12. The element (110, 111, 112, 113, 114, 115, 116, 117) according to any of claims 1-11, wherein the first metal layer (51) includes at least one selected from Si, Cu, Ni, and Au.

13. The element (110, 111, 112, 113, 114, 115, 116, 117) according to any of claims 1-12, wherein the second metal layer (52) includes at least one selected from Ni, Ag, and Al.

14. The element (110, 111, 112, 113, 114, 115, 116, 117) according to any of claim 1-13, wherein a length of the first metal layer (51) in the first direction is not less than 5 times a length of the stacked body (SB) in the first direction.

15. The element (113, 114, 115, 116) according to any of claims 1-10, wherein
the second semiconductor layer (20) is disposed between the first semiconductor layer (10) and the first metal layer (51),
a length of the first semiconductor layer (10) in a second direction perpendicular to the first direction is shorter than a length of the light emitting layer (30) in the second direction, and
the length of the light emitting layer (30) in the second direction is shorter than a length of the second semiconductor layer (20) in the second direction.

16. The element (117) according to any of claims 1-15, further comprising a wavelength conversion layer (202) configured to cover the stacked body (SB), oppose the side surface (51s) of the first metal layer (51), and cover at least a portion of the second metal layer (52) to convert a wavelength of light emitted from the light emitting layer (30).

17. A light emitting device (210, 212), comprising:
a semiconductor light emitting element (110, 111, 112, 113, 114, 115, 116, 117) according to any of claims 1-16;
a mounting substrate (200) supporting the semiconductor light emitting element (110, 111, 112, 113, 114, 115, 116, 117); and
a wavelength conversion layer (202) configured to cover the element (110, 111, 112, 113, 114, 115, 116, 117), cover at least a portion of the mounting substrate (200), oppose the side surface (51 s) of the first metal layer (51), and cover at least a portion of the second metal layer (52) to convert a wavelength of light emitted from the light emitting layer (30).

18. The device (210, 212) according to claim 17, further comprising a reflective layer (204) provided between the mounting substrate (200) and the wavelength conversion layer (202),
a reflectance of the reflective layer (204) being higher than a reflectance of the mounting substrate (200).

19. The device (212) according to any of claims 17 and 18, wherein
the mounting substrate (200) has a recess (200a), and
the semiconductor light emitting element (110, 111, 112, 113, 114, 115, 116, 117) is provided inside the recess (200a).

20. A method for manufacturing a semiconductor light emitting element (110, 111, 112, 113, 114, 115, 116, 117), comprising:
preparing a workpiece (110w) including
a growth substrate (5), and
a stacked film (SF) provided on the growth substrate (5), the stacked film (SF) including:
a first semiconductor film (10f) of a first conductivity type;
a second semiconductor film (20f) of a second conductivity type separated from the first semiconductor film (10f) in a stacking direction of the growth substrate (5) and the stacked film (10f); and
a light emitting film (30f) provided between the first semiconductor film (10f) and the second semiconductor film (20f);
forming a plurality of metal layers (51) on the stacked film (SF), each of the metal layers (51) having a side surface (51s) extending in the stacking direction; and
forming a metal film (52f) on the stacked film (SF) and on each of the metal layers (51 s) to cover at least a portion of the side surface (51 s) of each of the metal layers (51), a reflectance of the metal film (52f) being higher than a reflectance of each of the metal layers (51).

21. The method according to claim 20, wherein the forming of the metal layers (51) includes:
forming a mask layer (55) on the stacked film (SF), the mask layer (55) having a plurality of openings (55a); and
forming the metal layers (51) by depositing a metal material on a portion of the stacked film (SF) overlapping each of the openings (55a) when projected onto a plane perpendicular to the stacking direction.

22. The method according to claim 20, wherein the forming of the metal layers (51) includes:
adhering a support substrate (6) to the stacked film (SF); and
forming the metal layers (51) from the support substrate (6) by removing a portion of the support substrate (6).
